# EUROPEAN PATENT APPLICATION

(11) **EP 4 498 780 A1**
(43) Date of publication of application: **29.01.2025**
(21) Application number: 24188043.4
(22) Date of filing: 11.07.2024
(51) Int. Cl.: H10K 59/122, H10K 59/40, H10K 59/80

(54) **DISPLAY DEVICE AND METHOD OF MANUFACTURING THE SAME**

(30) Priority: 25.07.2023 KR 20230096966
(71) Applicant: Samsung Display Co., Ltd., Gyeonggi-Do (KR)
(72) Inventor: Sung, Woo Yong, Yongin-si, Gyeonggi-do (KR)
(74) Representative: Gulde & Partner

(57) **Abstract**

A display device (1000) includes: a base layer (110) including a light emitting area (PXA) and a non-light-emitting area (NPXA) surrounding the light emitting area (PXA); a light emitting element layer (130) disposed on the base layer (110) and including light emitting elements (EL); a pixel definition layer (PDL) disposed on the base layer (110) and provided with light emitting openings (PDL-OP) overlapping the light emitting elements (EL); a barrier wall (PW) including a first barrier wall layer (L1) disposed on the pixel definition layer (PDL) and a second barrier wall layer (L2) disposed on the first barrier wall layer (L1), where the barrier wall (PW) is provided with barrier wall openings (PW-OP) overlapping the light emitting openings (PDL-OP); an encapsulation layer (140) covering the light emitting elements (EL); and a sensor layer (200) disposed on the encapsulation layer (140). The encapsulation layer includes a first cover layer (CL1) covering the light emitting element layer (130) and the barrier wall (PW), a second cover layer (CL2) provided with groove portions (GR) defined therein and a third cover layer (CL3) disposed on the second cover layer (CL2), wherein light blocking patterns (BM) are disposed in the groove portions (GR).

## Description

### BACKGROUND

### 1. Field of disclosure

The present disclosure relates to a display device including an encapsulation layer with a function of controlling a directionality of light.

### 2. Description of the Related Art

Multimedia display devices, such as televisions, mobile phones, tablet computers, navigation devices, and game devices, include a display device displaying images. It is desirable to control a directionality of light traveling through the display device to protect a user's privacy, however, when the display device includes a separate light control member to control the directionality of light, an overall thickness of the display device increases.

### SUMMARY

The present disclosure provides a display device including an encapsulation layer with a function of controlling a directionality of light.

The present disclosure provides a method of manufacturing the display device including the encapsulation layer with the function of controlling the directionality of light.

Embodiments of the invention provide a display device including: a base layer including a light emitting area and a non-light-emitting area surrounding the light emitting area; a light emitting element layer disposed on the base layer and including light emitting elements; a pixel definition layer disposed on the base layer and provided with light emitting openings overlapping the light emitting elements in a plan view; a barrier wall including a first barrier wall layer disposed on the pixel definition layer and a second barrier wall layer disposed on the first barrier wall layer, where the barrier wall is provided with barrier wall openings overlapping the light emitting openings in the plan view; an encapsulation layer covering the light emitting elements; and a sensor layer disposed on the encapsulation layer. The encapsulation layer includes: a first cover layer covering the light emitting element layer and the barrier wall; a second cover layer disposed on the first cover layer and provided with groove portions, where the groove portions are defined therein by recessing portions of the second cover layer from an upper surface of the second cover layer and spaced apart from each other; a third cover layer disposed on the second cover layer; and light blocking patterns disposed in the groove portions.

The light blocking patterns may be arranged in one direction, and each of the light blocking patterns may have a rectangular shape in a cross-section parallel to the one direction and substantially perpendicular to a upper surface of the base layer.

The light blocking patterns may include a carbon black or a graphene.

The light blocking patterns may have a dielectric constant equal to or greater than 1 Farad per meter (F/m) and equal to or smaller than 3 F/m.

Each of the groove portions may have a width equal to or greater than 0.1 micrometers and equal to or smaller than 10 micrometers, and a separation distance between two of the groove portions adjacent to each other may be equal to or greater than 0.1 micrometers and equal to or smaller than 10 micrometers.

Each of the light blocking patterns may have a width equal to or greater than 1 micrometers and equal to or smaller than 1.5 micrometers, each of the light blocking patterns may have a height equal to or greater than 4.5 micrometers and equal to or smaller than 10 micrometers, and a separation distance between two of the light blocking patterns adjacent to each other may be equal to or greater than 1 micrometers and equal to or smaller than 100 micrometers.

The first cover layer may include at least one of silicon nitride, silicon oxynitride, silicon oxide, titanium oxide, and aluminum oxide, the second cover layer may include at least one of an acrylic resin, an epoxy resin, and a silicon oxycarbide, and the third cover layer may include at least one of silicon oxide, metal oxide, and metal.

At least a portion of the first cover layer, which covers an upper surface of the second barrier wall layer may be exposed through the groove portions in the non-light emitting area and be in contact with the third cover layer.

The light blocking patterns may include: first light blocking patterns having a first height and second light blocking patterns having a second height smaller than the first height, and the first light blocking patterns may be spaced apart from the barrier wall, and the second light blocking patterns may overlap the barrier wall in the plan view.

The light blocking patterns may further include third light blocking patterns having a third height, the third light blocking patterns may be spaced apart from the barrier wall in the plan view, and the third height may be different from the second height. Preferably, the third height iss maller than the second height.

The groove portions may each have a depth smaller than a distance from an upper surface of the second cover layer to an upper surface of the first cover layer in the non-light-emitting area, and a portion of the first cover layer covering an upper surface of the second barrier wall layer may be spaced apart from the third cover layer with the second cover layer interposed therebetween.

The light blocking patterns may be arranged in one direction, and in a cross-section parallel to the one direction and substantially perpendicular to the base layer, each of the light blocking patterns may have a shape whose width decreases in a direction from a lower portion to an upper portion thereof.

Each of the light emitting elements may include: a first electrode disposed in a corresponding barrier wall opening among the barrier wall openings; a light emitting layer disposed on the first electrode; and a second electrode disposed on the light emitting layer, and the second electrodes may be in contact with the first barrier wall layer, the first barrier wall layer may include aluminum, and the second barrier wall layer may include titanium.

The sensor layer may include: a first sensing insulating layer disposed on the third cover layer, a first conductive layer disposed on the first sensing insulating layer, a second sensing insulating layer disposed on the first sensing insulating layer and covering the first conductive layer, and a second conductive layer disposed on the second sensing insulating layer.

The display device may further include: an optical layer disposed on the sensor layer, an adhesive layer disposed on the optical layer, and a window disposed on the adhesive layer, and the optical layer may be attached to the window by the adhesive layer.

A side surface of the second barrier wall layer may protrude more than the first barrier wall layer, and a protruded portion of the side surface of the second barrier wall layer may overlap a portion of the light emitting elements in the plan view.

The pixel definition layer may be disposed between the first electrode and the first barrier wall layer to prevent the first electrode from being electrically connected to the first barrier wall layer.

Embodiments of the invention provide a method of manufacturing a display device. The method includes: providing a preliminary display device including a base layer, a light emitting element layer disposed on the base layer and including light emitting elements, a pixel definition layer disposed on the base layer and provided with light emitting openings overlapping the light emitting elements in a plan view, a barrier wall including a first barrier wall layer disposed on the pixel definition layer and a second barrier wall layer disposed on the first barrier wall layer, where the barrier wall is provided with barrier wall openings overlapping the light emitting openings in the plan view; forming a first cover layer to cover the light emitting element layer and the barrier wall; forming a second cover layer on the first cover layer; forming groove portions defined in the second cover layer and spaced apart from each other by removing portions of the second cover layer from an upper surface of the second cover layer; forming a third cover layer to cover side surfaces of the groove portions and an upper surface of the second cover layer; forming light blocking patterns in an inner space of the groove portions; and forming a sensor layer disposed on the third cover layer.

The forming of the groove portions may include dry-etching the portions of the second cover layer from the upper surface of the second cover layer.

The forming of the light blocking patterns may include removing a upper remaining layer including a material for the light blocking patterns and disposed outside of the groove portions. The removing of the upper remaining layer may be performed by a chemical mechanical polishing process or an ashing process.

According to the above, as the pattern that controls the directionality of the light is disposed in the encapsulation layer, a total thickness of the display device is reduced while controlling the directionality of the light. Accordingly, a dielectric constant of the display device is effectively reduced.

### BRIEF DESCRIPTION OF THE DRAWINGS

The above and other advantages of the present disclosure will become readily apparent by reference to the following detailed description when considered in conjunction with the accompanying drawings wherein:
FIG. 1 is a perspective view of a display device according to an embodiment of the present disclosure;
FIG. 2 is a cross-sectional view of a display device according to an embodiment of the present disclosure;
FIG. 3A is a cross-sectional view of a display device according to an embodiment of the present disclosure;
FIG. 3B is an enlarged cross-sectional view of a portion A of the display device of Fig. 3A;
FIG. 4A is a cross-sectional view of a display device according to another embodiment of the present disclosure;
FIG. 4B is a cross-sectional view of a display device according to still another embodiment of the present disclosure;
FIG. 4C is a cross-sectional view of a display device according to yet another embodiment of the present disclosure;
FIG. 4D is a cross-sectional view of a display device according to still another embodiment of the present disclosure; and
FIGS. 5A to 5K are cross-sectional views illustrating a method of manufacturing a display device according to an embodiment of the present disclosure.

### DETAILED DESCRIPTION

The present disclosure may be variously modified and realized in many different forms, and thus specific embodiments will be exemplified in the drawings and described in detail hereinbelow. However, the present disclosure should not be limited to the specific disclosed forms, and be construed to include all modifications, equivalents, or replacements included in the scope of the present disclosure.

In the present disclosure, it will be understood that when an element (or area, layer, or portion) is referred to as being "on", "connected to" or "coupled to" another element or layer, it can be directly on, connected or coupled to the other element or layer or intervening elements or layers may be present.

Like numerals refer to like elements throughout. In the drawings, the thickness, ratio, and dimension of components are exaggerated for effective description of the technical content. As used herein, the term "and/or" may include any and all combinations of one or more of the associated listed items.

It will be understood that, although the terms first, second, etc. may be used herein to describe various elements, these elements should not be limited by these terms. These terms are only used to distinguish one element from another element. Thus, a first element discussed below could be termed a second element without departing from the teachings of the present disclosure. As used herein, the singular forms, "a", "an" and "the" are intended to include the plural forms as well, unless the context clearly indicates otherwise.

Spatially relative terms, such as "beneath", "below", "lower", "above", "upper" and the like, may be used herein for ease of description to describe one element or feature's relationship to another elements or features as shown in the figures.

It will be further understood that the terms "include" and/or "including", when used in this specification, specify the presence of stated features, integers, steps, operations, elements, and/or components, but do not preclude the presence or addition of one or more other features, integers, steps, operations, elements, components, and/or groups thereof.

Unless otherwise defined, all terms including technical and scientific terms used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein. Hereinafter, embodiments of the present disclosure will be described with reference to accompanying drawings.

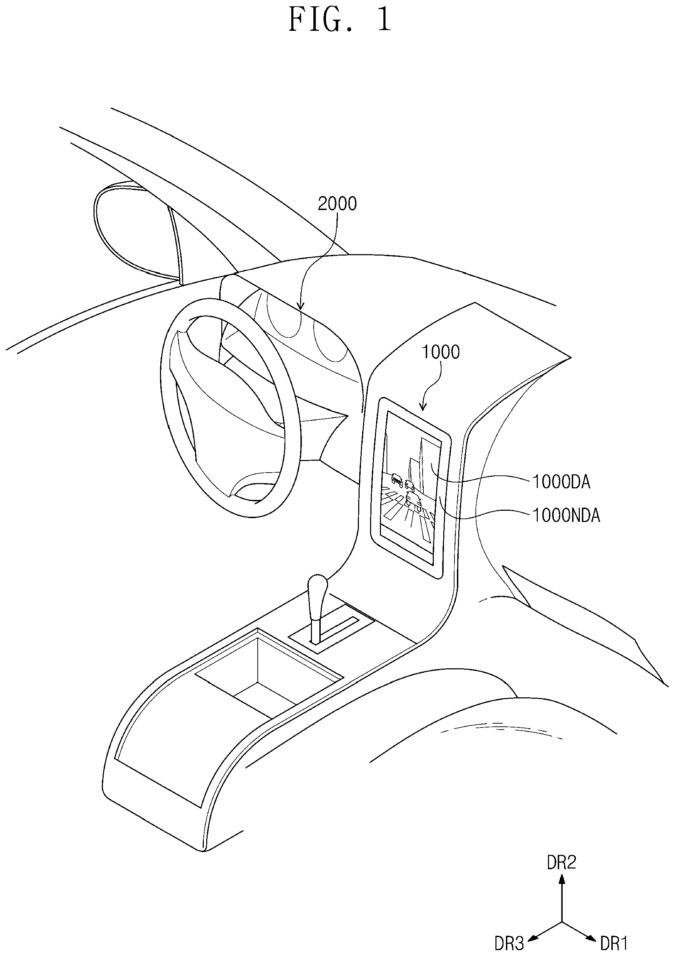

FIG. 1 is a perspective view of a display device 1000 according to an embodiment of the present disclosure.

The display device 1000 shown in FIG. 1 may be a center information display ("CID") for a vehicle.

Referring to FIG. 1, the display device 1000 may include a display area 1000DA and a non-display area 1000NDA. An image is displayed through the display area 1000DA. FIG. 1 shows a traffic situation as an examplary image. The image is not displayed through the non-display area 1000NDA. The display area 1000DA may be substantially parallel to a plane defined by a first direction DR1 and a second direction DR2 intersecting the first direction DR1.

The display device 1000 may be activated in response to electrical signals. The display device 1000 may be applied to various embodiments. For example, the display device 1000 may be applied to various means of transportation, such as cars, bicycles, motorcycles, ships, airplanes, etc., however, this is merely an example. The display device 1000 may be applied to other electronic devices as long as they do not depart from the invention of the present disclosure.

According to an embodiment, a display device 2000 may be provided in the form of a display included in a digital dash. The display device 2000 may include a display area and a non-display area defined therein, and the display area and the non-display area of the display device 2000 may correspond to the display area 1000DA and the non-display area 1000NDA of the display device 1000. Therefore, redundant explanations are omitted.

In the following descriptions, upper (or front) and lower (or rear) surfaces of each member may be defined with respect to a direction (i.e., a third direction DR3) in which the image is displayed. The upper and lower surfaces may face each other in the third direction DR3, and a normal line direction of each of the upper and lower surfaces may be substantially parallel to the third direction DR3. As used herein, a "plan view" is a view in the normal line direction (i.e., a third direction DR3). Meanwhile, directions indicated by the first, second, and third directions DR1, DR2, and DR3 may be relative to each other and may be changed to other directions. Hereinafter, the first, second, and third directions refer to the same reference numerals as directions indicated by the first, second, and third directional axes DR1, DR2, and DR3, respectively.

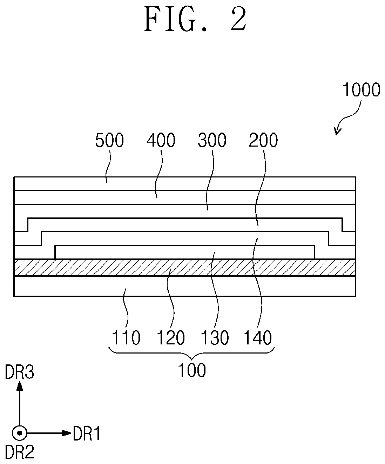

FIG. 2 is a cross-sectional view of the display device 1000 according to an embodiment of the present disclosure.

Referring to FIG. 2, the display device 1000 may include a display layer 100, a sensor layer 200, an optical layer 300, an adhesive layer 400, and a window 500, however, this is merely an example. The display device 1000 may not include the window 500.

The display layer 100 may include a base layer 110, a circuit layer 120, a light emitting element layer 130, and an encapsulation layer 140.

The base layer 110 may be disposed at a lowermost position in the display device 1000 and may provide a base surface on which other components of the display device 1000 are disposed. The base layer 110 may be a glass substrate, a metal substrate, a silicon substrate, or a polymer substrate, however, the present disclosure should not be limited thereto or thereby. According to an embodiment, the base layer 110 may be an inorganic layer, an organic layer, or a composite material layer.

The circuit layer 120 may be disposed on the base layer 110. The circuit layer 120 may include an insulating layer, a semiconductor pattern, a conductive pattern, and a signal line. An insulating layer, a semiconductor layer, and a conductive layer may be formed on the base layer 110 by a coating or depositing process. Then, the insulating layer, the semiconductor layer, and the conductive layer may be selectively patterned through several photolithography processes. Thus, the semiconductor pattern, the conductive pattern, and the signal line included in the circuit layer 120 may be formed.

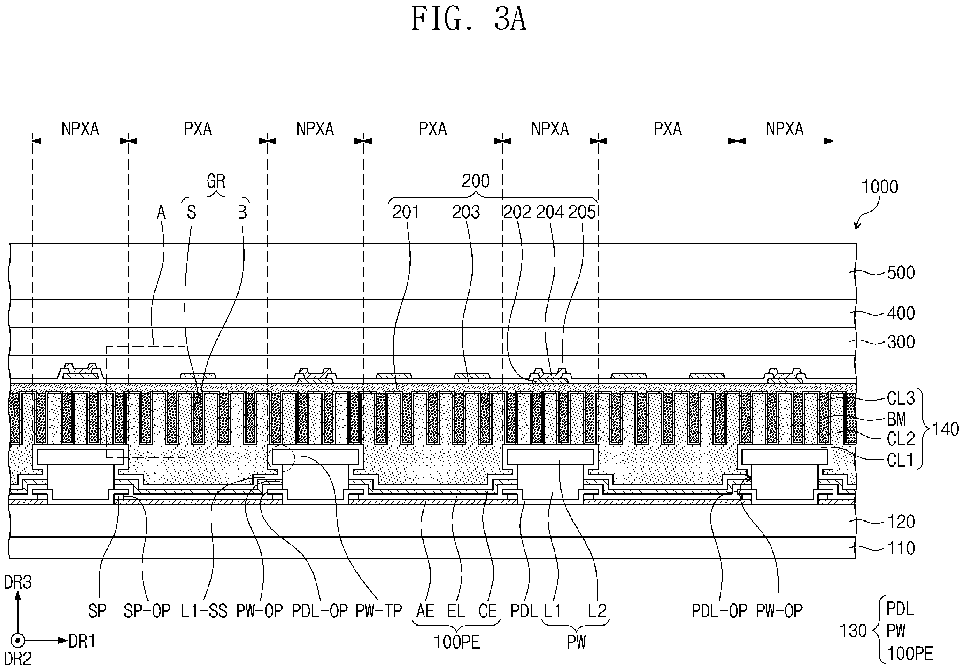

The light emitting element layer 130 may be disposed on the circuit layer 120. The light emitting element layer 130 may include a light emitting element 100PE (refer to FIG. 3A). In an embodiment, for example, the light emitting element layer 130 may include an organic light emitting material, an inorganic light emitting material, an organic-inorganic light emitting material, a quantum dot, a quantum rod, a micro-LED, or a nano-LED.

The encapsulation layer 140 may be disposed on the circuit layer 120. The encapsulation layer 140 may protect the light emitting element layer 130 from moisture, oxygen, and a foreign substance, such as dust particles. Accordingly, the encapsulation layer 140 may improve a reliability of the display device 1000. In addition, the encapsulation layer 140 may include light blocking patterns BM (refer to FIG. 3A). Accordingly, the encapsulation layer 140 may control the light transmitting therethrough, and details thereof will be described later.

The sensor layer 200 may be disposed on the display layer 100. The sensor layer 200 may be formed on the display layer 100 through successive processes. In this case, the sensor layer 200 may be expressed as being placed directly on the display layer 100. In the present disclosure, the expression "The sensor layer 200 is disposed directly on the display layer 100." means that no intervening elements are present between the sensor layer 200 and the display layer 100. That is, a separate adhesive member may not be disposed between the sensor layer 200 and the display layer 100.

According to an embodiment, the sensor layer 200 may be coupled with the display layer 100 by an adhesive member. The adhesive member may include a conventional adhesive. The sensor layer 200 may convert an input from the outside of the display device 1000 to an electrical signal.

The optical layer 300 may be disposed on the sensor layer 200, however, it should not be limited thereto or thereby. According to an embodiment, an adhesive member may be disposed between the optical layer 300 and the sensor layer 200. The optical layer 300 may be a reflection-reducing layer that reduces a reflectance with respect to an external light incident thereto from the outside of the display device 1000. The optical layer 300 may be formed on the sensor layer 200 through successive processes.

In an embodiment, for example, the optical layer may include a polarizing film including a retarder and/or a polarizer, multiple layers of reflective layers that allow reflected lights to destructively interfere with each other, or color filters disposed to correspond to an arrangement and emission color of pixels of a display unit. In an embodiment, for example, in a case where the optical layer 300 includes the color filters, the color filters may be arranged by taking into account the emission color of the pixels included in the display layer 100. According to an embodiment, the optical layer 300 may be omitted.

The adhesive layer 400 may be disposed on the optical layer 300. The adhesive layer 400 may attach the optical layer 300 to the window 500. The adhesive layer 400 may include an optically clear adhesive ("OCA"), however, this is merely an example. According to further embodiments, the adhesive layer 400 may include another optically transparent material.

The window 500 may be disposed on the adhesive layer 400. The window 500 may be disposed at an uppermost position of the display device 1000 and may protect the display device 1000 from external impacts. The window 500 may include an optically transparent insulating material. In an embodiment, for example, the window 500 may include a glass or plastic material.

The window 500 may have a single-layer or multi-layer structure. In an embodiment, for example, the window 500 may include a plurality of plastic films coupled with each other by an adhesive or a glass substrate and a plastic film coupled with the glass substrate by an adhesive.

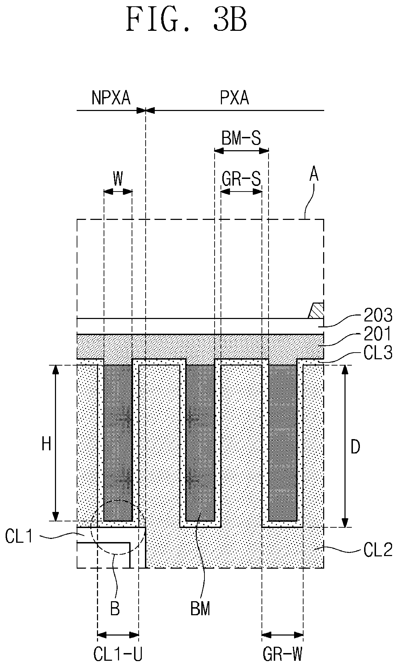

FIG. 3A is a cross-sectional view of a display device 1000 according to an embodiment of the present disclosure. FIG. 3B is an enlarged cross-sectional view of a portion of the display device 1000 according to an embodiment of the present disclosure. The enlarged portion shown in FIG. 3B is an area A in FIG. 3A.

Referring to FIGS. 3A and 3B, the display device 1000 may include a base layer 110, a circuit layer 120, a light emitting element layer 130, an encapsulation layer 140, a sensor layer 200, an optical layer 300, an adhesive layer 400, and a window 500. In FIGS. 3A and 3B, the same reference numerals denote the same elements in FIG. 2, and thus, detailed descriptions of said elements will be omitted.

The display area 1000DA (refer to FIG. 1) may include a light emitting area PXA and a non-light-emitting area NPXA surrounding the light emitting area PXA. The light emitting area PXA may be defined as an area where an upper surface of a second electrode CE is exposed through a light emitting opening PDL-OP described later. The non-light-emitting area NPXA may define a boundary between light emitting areas PXA-R, PXA-G, and PXA-B and may prevent a color mixture between the light emitting areas PXA-R, PXA-G, and PXA-B.

The light emitting element layer 130 may be disposed on the circuit layer 120. The light emitting element layer 130 may include a pixel definition layer PDL, a barrier wall PW, and the light emitting elements 100PE.

The pixel definition layer PDL may be disposed on the circuit layer 120. The light emitting opening PDL-OP may be defined through the pixel definition layer PDL. The light emitting opening PDL-OP may overlap a first electrode AE in a plan view, and at least a portion of the first electrode AE may be exposed through the light emitting opening PDL-OP of the pixel definition layer PDL.

The pixel definition layer PDL may include an inorganic insulating material. In an embodiment, for example, the pixel definition layer PDL may include silicon nitride (SiNx). The pixel definition layer PDL may be disposed between the first electrode AE and a first barrier wall layer L1 and may prevent the first electrode AE from being electrically connected with the first barrier wall layer L1.

The barrier wall PW may be disposed on the pixel definition layer PDL. A barrier wall opening PW-OP may be defined by the barrier wall PW. The barrier wall opening PW-OP may overlap the light emitting opening PDL-OP in a plan view, and at least a portion of the first electrode AE may be exposed through the barrier wall opening PW-OP.

The barrier wall PW may have an undercut shape when viewed in a cross-section. The barrier wall PW may include a plurality of layers sequentially stacked, and at least one layer of the layers may be more recessed than the other layers. Accordingly, the barrier wall PW may include a tip portion PW-TP described later.

The barrier wall PW may include the first barrier wall layer L1 disposed on the pixel definition layer PDL and a second barrier wall layer L2 disposed on the first barrier wall layer L1.

A length of the first barrier wall layer L1 may be smaller than a length of the second barrier wall layer L2 in the first direction DR1. Accordingly, the first barrier wall layer L1 may be more recessed from the light emitting area PXA than the second barrier wall layer L2, and the second barrier wall layer L2 may include the tip portion PW-TP that is a protruded side surface.

The first barrier wall layer L1 may include a material with a conductivity greater than a material of the second barrier wall layer L2. In an embodiment, for example, the first barrier wall layer L1 may include aluminum, and the second barrier wall layer L2 may include titanium.

The light emitting element 100PE may be disposed on the base layer 110. The light emitting element 100PE may emit a light with a predetermined brightness in response to a current provided from a pixel circuit.

The light emitting element 100PE may include the first electrode AE, a light emitting layer EL, and a second electrode CE. According to an embodiment, the first electrode AE may be referred to as an anode, and the second electrode CE may be referred to as a cathode.

The first electrode AE may be disposed on the circuit layer 120. The first electrode AE may be disposed inside the light emitting opening PDL-OP. The light emitting layer EL may cover a portion of an upper surface of the pixel definition layer PDL exposed through the light emitting opening PDL-OP.

The first electrode AE may be electrically connected to a connection signal line via connection electrodes and may be electrically connected to a corresponding circuit element (not shown).

The first electrode AE may have a single-layer or multi-layer structure. In an embodiment, for example, the first electrode AE may include a layer including indium tin oxide ("ITO", hereinafter, referred to as a lower ITO layer), a layer including silver (Ag, hereinafter, referred to as an Ag layer) disposed on the lower ITO layer, a layer including ITO and disposed on the Ag layer (hereinafter, referred to as an upper ITO layer).

A sacrificial pattern SP may be disposed between the first electrode AE and the pixel definition layer PDL. A sacrificial opening SP-OP may be defined through the sacrificial pattern SP to expose a portion of an upper surface of the first electrode AE. The sacrificial opening SP-OP may overlap the light emitting opening PDL-OP in a plan view. The sacrificial pattern SP may include an amorphous transparent conductive oxide. The sacrificial pattern SP may include an azo compound. In an embodiment, for example, the sacrificial pattern SP may include zinc oxide (ZnOₓ) doped with aluminum (Al). In this case, a content of aluminum (Al) may be equal to or greater than 2 at% and equal to or smaller than 5 at%.

The light emitting layer EL may be disposed on the first electrode AE. The light emitting layer EL may be disposed inside the light emitting opening PDL-OP. The light emitting layer EL may cover the portion of the upper surface of the pixel definition layer PDL exposed through the barrier wall opening PW-OP. The light emitting layer EL may be an area where electrons are recombined with holes to emit the light. The light emitting layer EL may include a light emitting material.

FIG. 3A shows a structure in which the light emitting layer EL is in contact with a side surface L1-SS of the first barrier wall layer L1 as a representative example, however, the present disclosure should not be limited thereto or thereby. According to an embodiment, the light emitting layer EL may not be in contact with the side surface L1-SS of the first barrier wall layer L1.

The second electrode CE may be disposed on the light emitting layer EL. The second electrode CE may be disposed inside the light emitting opening PDL-OP, and the second electrode CE may be in contact with the side surface L1-SS of the first barrier wall layer L1. The barrier wall PW may include a conductive material and may receive a driving voltage. Accordingly, the second electrode CE electrically connected to the barrier wall PW may receive the driving voltage.

According to an embodiment, the light emitting elements 100PE may be commonly formed using an open mask but may be divided in the unit of pixel by the barrier wall PW. Accordingly, different from a case where a fine metal mask ("FMM") is used to pattern the light emitting elements 100PE, there is no need to provide a support spacer protruded from the barrier wall, and defects in the display device 1000, which are caused when the support spacer is damaged by the fine metal mask, may be prevented.

In addition, as the patterning the light emitting elements 100PE is possible even though a separate support spacer protruded from the barrier wall PW is not provided, sizes of the light emitting areas PXA may be reduced. Accordingly, the display device 1000 may have a high resolution.

In addition, the light emitting elements 100PE adjacent to each other may be physically separated from each other. Accordingly, a current leakage and a color mixture between adjacent light emitting elements 100PE may be effectively prevented.

According to an embodiment, the light emitting element layer 130 may further include a capping pattern (not shown). The capping pattern may be disposed in the barrier wall opening PW-OP and may be disposed on the second electrode CE. The capping pattern may be patterned by the tip portion PW-TP formed in the barrier wall PW.

The encapsulation layer 140 may be disposed on the light emitting element layer 130.

The encapsulation layer 140 may include a first cover layer CL1, a second cover layer CL2 in which groove portions GR are defined, light blocking patterns BM, and a third cover layer CL3.

The first cover layer CL1 may be disposed on the light emitting elements 100PE and the barrier wall PW to cover at least portions of the light emitting elements 100PE and the barrier wall PW. The first cover layer CL1 may cover the upper surface of second electrode CE, the side surface L1-SS of the first barrier wall layer L1, which is in contact with the second electrode CE, and at least a portion of lower surface of the second barrier wall layer L2, which is exposed without being covered by the first barrier wall layer L1, and side and upper surfaces of the second barrier wall layer L2.

The first cover layer CL1 may be an inorganic layer. The first cover layer CL1 may protect the light emitting element layer 130 from moisture and oxygen. The first cover layer CL1 may include at least one of a silicon nitride layer, a silicon oxynitride layer, a silicon oxide layer, a titanium oxide layer, and an aluminum oxide layer.

The second cover layer CL2 may be disposed on the first cover layer CL1. The second cover layer CL2 may cover the first cover layer CL1. The second cover layer CL2 may be formed through a process of depositing an organic material, however, a method of forming the second cover layer CL2 should not be limited thereto or thereby. According to an embodiment, the second cover layer CL2 may be formed using an inkjet method that forms an organic layer by providing a liquid monomer on the first cover layer CL1, however, the present disclosure should not be limited thereto or thereby.

Each of the groove portions GR may be formed by recessing at least a portion of the second cover layer CL2 in a direction from an upper surface of the second cover layer CL2 toward a lower surface of the second cover layer CL2 and may be defined by outer surfaces of the second cover layer CL2. The groove portions GR may include groove portion side surfaces S substantially parallel to the third direction DR3. In addition, the groove portions GR may further include a groove portion lower surface B facing the base layer 110 in an area overlapping the non-light-emitting area NPXA.

Referring to FIG. 3A, the second cover layer CL2 may be completely removed in portions of the area overlapping the non-light-emitting area NPXA in the direction from the upper surface toward the lower surface. That is, the groove portions GR overlapping the non-light-emitting area NPXA may be formed completely penetrating the second cover layer CL2 from the upper surface to the lower surface of the second cover layer CL2.

Accordingly, the second cover layer CL2 may have a shape partially disconnected by the groove portions GR in the area overlapping the non-light-emitting area NPXA.

On the contrary, only a portion of the second cover layer CL2 may be removed in the direction from the upper surface to the lower surface of the second cover layer CL2 in a groove portion GR located in an area overlapping the light emitting area PXA. Accordingly, at least a portion of the second cover layer CL2 may remain under the groove portions GR overlapping the light emitting area PXA. That is, the second cover layer CL2 may not be completely penetrated in the light emitting area PXA, and the second cover layer CL2 may be provided between the first cover layer CL1 and the third cover layer CL3.

When viewed in the cross-section, the groove portions GR may be arranged in the first direction DR1. The groove portions GR may be arranged at a separation distance GR-S that is constant. In an embodiment, for example, the separation distance GR-S between the groove portions GR adjacent to each other in the first direction DR1 may be equal to or greater than 0.1 micrometers (µm) and equal to or smaller than 10 µm, however, the present disclosure should not be limited thereto or thereby. According to an embodiment, the groove portions GR may be arranged at a separation distance GR-S that is irregular.

When viewed in the cross-section, each of the groove portions GR may have a rectangular shape. A width GR-W in the first direction DR1 of each of the groove portions GR may be equal to or greater than 0.1 µm and equal to or smaller than 10 µm, however, the present disclosure should not be limited thereto or thereby. According to an embodiment, each of the groove portions GR in the cross-section may have a shape other than the rectangular shape, such as a polygonal shape and a figure having at least one curved side, and the width GR-W should not be limited to the above-described range.

When viewed in the cross-section, a depth D of the groove portions GR may be substantially the same as a thickness in the third direction DR3 of the second cover layer CL2 in the non-light-emitting area NPXA.

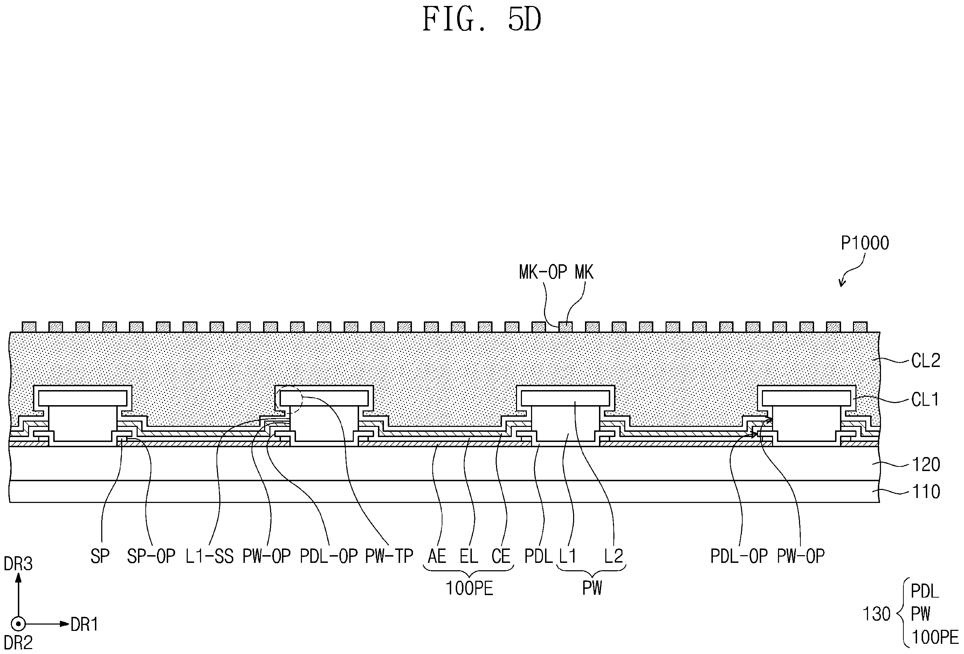

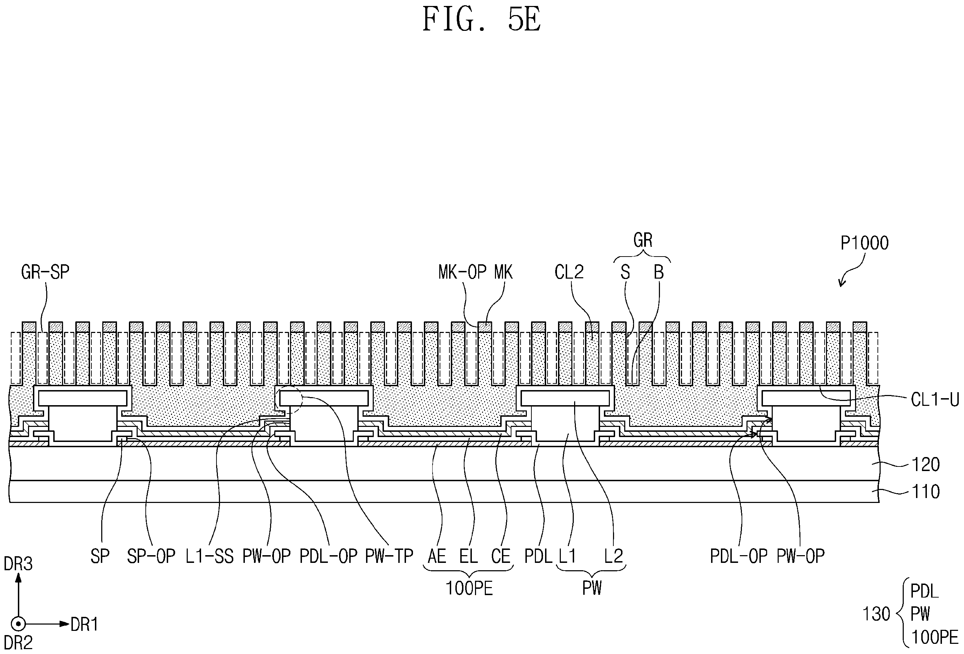

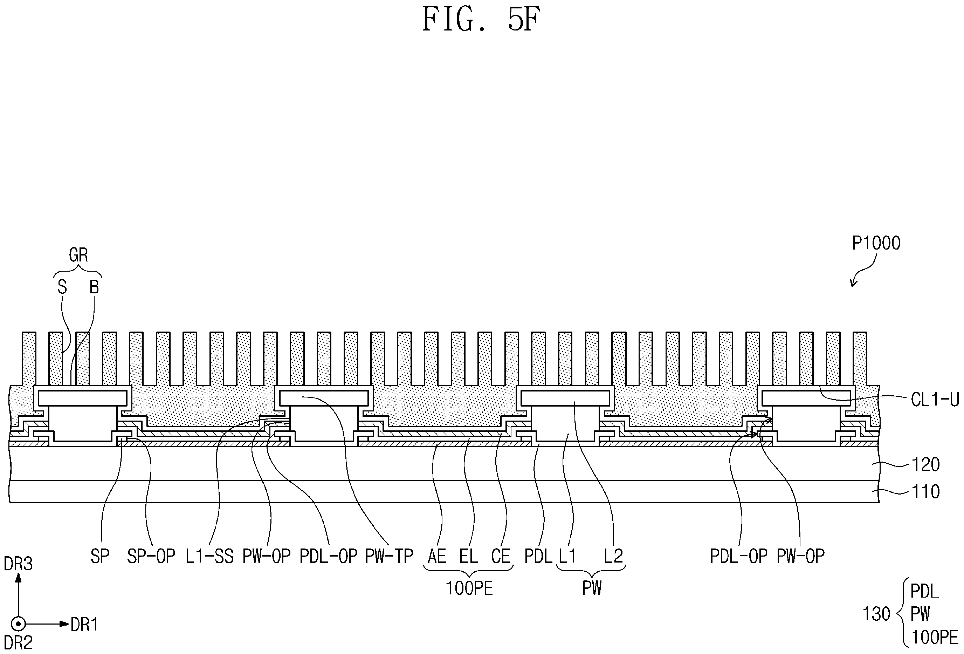

The light blocking patterns BM may be accommodated in an inner space GR-SP (refer to FIG. 5E) of the groove portions GR, which is defined by removing the second cover layer CL2, and the shape and arrangement of the light blocking patterns BM may be determined by the groove portions GR.

Since the groove portions GR overlapping the non-light-emitting area NPXA completely penetrate the second cover layer CL2 from the upper surface to the lower surface of the second cover layer CL2, at least a portion CL1-U of an upper surface of the first cover layer CL1 covering the second barrier wall layer L2 in the area overlapping the non-light-emitting area NPXA may be exposed without being covered by the second cover layer CL2 (See area B in FIG. 3B).

The third cover layer CL3 may cover the groove portion side surfaces S and the upper surface of the second cover layer CL2. In addition, the third cover layer CL3 may cover the groove portion lower surface B or the first cover layer CL1. In an embodiment, for example, since the groove portions GR are formed to completely penetrate the second cover layer CL2 in the area overlapping the non-light-emitting area NPXA, the third cover layer CL3 may cover a portion CL1-U of an upper surface of the first cover layer CL1.

The third cover layer CL3 may be formed by an atomic layer deposition ("ALD") method. Accordingly, a variation in thickness of the third cover layer CL3 may be alleviated, and thus, a step coverage may be improved. That is, the third cover layer CL3 may cover the upper surface of the second cover layer CL2, the groove portion lower surface B included in each of the groove portions GR, and the groove portion side surfaces S included in each of the groove portions GR, and thus, irregularities formed on the groove portion lower surface B and the groove portion side surfaces S during the process of forming the groove portion GR may be smoothed.

The third cover layer CL3 may include a material with a hydrophilic property, and the light blocking patterns BM may be easily filled in the inner space GR-SP (refer to FIG. 5E) of the groove portions GR. In an embodiment, for example, the third cover layer CL3 may include silicon oxide (SiOx), metal oxide, or a metal material, however, it should not be limited thereto or thereby.

The light blocking patterns BM may be disposed in the inner space GR-SP (refer to FIG. 5E) of the groove portions GR. The inner space GR-SP of the groove portions GR may correspond to a space surrounded by the groove portion side surfaces S in the second cover layer CL2.

Since the light blocking patterns BM are arranged in the inner space GR-SP (refer to FIG. 5E) of the groove portions GR, the arrangement of the light blocking patterns BM may be determined by the arrangement of the groove portions GR. FIG. 3A shows a structure in which the light blocking patterns BM are arranged at a uniform separation distance in the first direction DR1. Accordingly, the light blocking patterns BM may be arranged at a separation distance BM-S, which is uniform in the first direction DR1. In an embodiment, for example, the separation distance BM-S between the light blocking patterns BM adjacent to each other may be equal to or greater than 1 µm and equal to or smaller than 100 µm, however, the present disclosure should not be limited thereto or thereby. According to another embodiment, the groove portions GR may be arranged at a separation distance BM-S that is not uniform.

According to the present embodiment, a ratio of the number of the groove portions GR and the number of the light blocking patterns BM, which are arranged in the non-light-emitting area NPXA, to the number of the groove portions GR and the number of the light blocking patterns BM, which are arranged in the light emitting area PXA, may be 4:5, however, the present disclosure should not be limited thereto or thereby.

The light blocking patterns BM may be disposed in the inner space GR-SP (refer to FIG. 5E) of the groove portions GR, and thus, each of the light blocking patterns BM may have a shape determined by the shape of the groove portions GR.

The light blocking patterns BM may have a rectangular shape in a cross-section. In this case, each of the light blocking patterns BM may have a uniform width W and a uniform height H. In an embodiment, for example, the width W of each of the light blocking patterns BM may be equal to or greater than 1 µm and equal to or smaller than 1.5 µm, and the height H of each of the light blocking patterns BM may be equal to or greater than 4.5 µm and equal to or smaller than 10 µm, however, the present disclosure should not be limited thereto or thereby. According to an embodiment, the shape of the light blocking patterns BM in the cross-section may have a shape other than the rectangular shape, such as a polygonal shape and a figure having at least one curved side.

FIGS. 3A and 3B show the structure in which the widths W of the light blocking patterns BM are same. However, the present disclosure should not be limited thereto or thereby, and the widths W of the light blocking patterns BM may be different.

FIGS. 3A and 3B show the structure in which the heights H of the light blocking patterns BM are same.

Since the heights H of the light blocking patterns BM is same, lower surfaces of the light blocking patterns BM may be aligned with each other in the first direction DR1. However, the present disclosure should not be limited thereto or thereby, and the heights H of the light blocking patterns BM may be different.

Upper surfaces of the light blocking patterns BM may be aligned with each other in the first direction DR1.

The light blocking patterns BM may transmit or absorb the light emitted from the light emitting element layer 130 to limit an emission angle of the light.

The light blocking patterns BM may include a light-shielding material with a low dielectric constant. In an embodiment, for example, the light blocking patterns BM may include a carbon black or a graphene, and the dielectric constant of the light blocking patterns BM may be equal to or greater than 1 F/m and equal to or smaller than 3 F/m. However, the material of the light blocking patterns BM should not be particularly limited as long as the material has a light shielding property and a low dielectric constant.

In a case where a light incident into the light blocking patterns BM travels the space between light blocking patterns BM, a light path may be limited, and thus, a light emission angle may be limited. The light emission angle may be an angle formed between a light incident into the second cover layer CL2 from the light emitting element 100PE and an imaginary line (hereinafter, referred to as a normal line) indicated by the third direction DR3. The normal line may be substantially perpendicular to the upper and lower surfaces of the second cover layer CL2.

As the light emission angle is limited by the light blocking patterns BM, a range of angle at which the image displayed on the display device 1000 is viewed may be limited. In addition, the image displayed on the display device 1000 may be prevented from being reflected in other electronic products.

In an embodiment, for example, the image of the display device 1000 may be prevented from being reflected in a windshield of a vehicle equipped with the display device 1000. As the image of the display device is not reflected in the windshield of the vehicle, a driver's view may not be disturbed by the reflected image.

The structure of the encapsulation layer 140 should not be limited thereto or thereby and may further include additional elements. In an embodiment, for example, the encapsulation layer 140 may further include an inorganic layer or an organic layer.

The sensor layer 200 may be disposed on the encapsulation layer 140. The sensor layer 200 may include a first sensing insulating layer 201, a first conductive layer 202, a second sensing insulating layer 203, a second conductive layer 204, and a cover insulating layer 205.

The first sensing insulating layer 201 may be disposed on the encapsulation layer 140. The first sensing insulating layer 201 may protect the light emitting element layer 130 from moisture and oxygen. The first sensing insulating layer 201 may include a silicon nitride layer, a silicon oxynitride layer, a silicon oxide layer, a titanium oxide layer, or an aluminum oxide layer.

The sensor layer 200 may further include a base insulating layer disposed between the first sensing insulating layer 201 and the first conductive layer 202. The base insulating layer may be an inorganic layer containing at least one of silicon nitride, silicon oxynitride, and silicon oxide. In addition, the base insulating layer may be an organic layer containing an epoxy resin, an acrylic resin, or an imide-based resin. The base insulating layer may have a single-layer structure or a multi-layer structure of layers stacked in the third direction DR3.

Each of the first conductive layer 202 and the second conductive layer 204 may have a single-layer structure or a multi-layer structure of layers stacked in the third direction DR3. The conductive layer having the single-layer structure may include a metal layer or a transparent conductive layer. The metal layer may include molybdenum, silver, titanium, copper, aluminum, or alloys thereof. The transparent conductive layer may include a transparent conductive oxide, such as indium tin oxide (ITO), indium zinc oxide ("IZO"), zinc oxide (ZnO), or indium zinc tin oxide ("IZTO"). In addition, the transparent conductive layer may include a conductive polymer (e.g., poly 3,4-ethylenedioxythiophene: PEDOT), a metal nanowire, a graphene, or the like.

The conductive layer having the multi-layer structure may include a plurality of metal layers. The metal layers may have a three-layer structure of titanium(Ti)/aluminum(AI)/titanium(Ti). The conductive layer having the multi-layer structure may include at least one metal layer and at least one transparent conductive layer.

At least one of the second sensing insulating layer 203 and the cover insulating layer 205 may include an inorganic layer. The inorganic layer may include at least one of aluminum oxide, titanium oxide, silicon oxide, silicon nitride, silicon oxynitride, zirconium oxide, and hafnium oxide.

At least one of the second sensing insulating layer 203 and the cover insulating layer 205 may include an organic layer. The organic layer may include at least one of an acrylic-based resin, a methacrylic-based resin, a polyisoprene-based resin, a vinyl-based resin, an epoxy-based resin, a urethane-based resin, a cellulose-based resin, a siloxane-based resin, a polyimide-based resin, a polyamide-based resin, and a perylene-based resin.

The optical layer 300, the adhesive layer 400, and the window 500 may be sequentially stacked on the sensor layer 200. Descriptions about the stack structure of the optical layer 300, the adhesive layer 400, and the window 500 are substantially the same as those described with reference to FIG. 2, and details of the same elements will not be repeated.

According to an embodiment, the display device 1000 may not include a separate layer on which the light blocking patterns BM are disposed, and the light blocking patterns BM may be disposed in the encapsulation layer 140. Accordingly, the encapsulation layer 140, may perform both the function of blocking moisture and oxygen from permeating into the light emitting element layer 130 and the function of limiting the emission angle of the light emitted from the light emitting element layer 130. Therefore, a total thickness of the display device 1000 may be reduced.

In addition, as the total thickness of the display device 1000 is reduced, the dielectric constant of the display device 1000 may be reduced. Accordingly, a noise caused by a coupling between the sensor layer 200 and the second electrode CE may be reduced. Therefore, a signal-to-noise ratio (SNR) may be reduced, and the display device 1000 may include the sensor layer 200 with improved sensitivity.

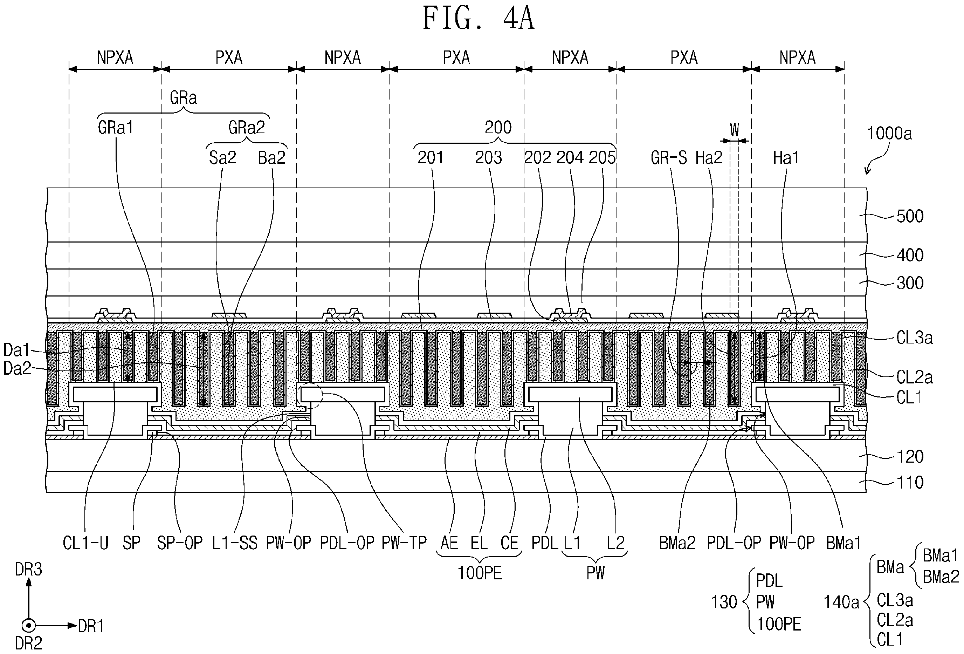

FIG. 4A is a cross-sectional view of a display device 1000a according to another embodiment of the present disclosure.

Hereinafter, a stack structure of the display device 1000a will be described with reference to FIG. 4A.

The display device 1000a may include a base layer 110, a circuit layer 120, a light emitting element layer 130, an encapsulation layer 140a, a sensor layer 200, an optical layer 300, an adhesive layer 400, and a window 500.

In FIG. 4A, the same reference numerals denote the same elements in FIGS. 3A and 3B, and detailed descriptions of said elements will be omitted. The following descriptions will be focused on different features.

The encapsulation layer 140a may be disposed on the light emitting element layer 130. The encapsulation layer 140a may include a first cover layer CL1, a second cover layer CL2a in which groove portions GRa are defined, light blocking patterns BMa, and a third cover layer CL3a.

Each of the groove portions GRa may be defined by outer surfaces of the second cover layer CL2a, which are defined by removing at least a portion of the second cover layer CL2a from an upper surface to a lower surface of the second cover layer CL2a.

The groove portions GRa may include first groove portions GRa1 and second groove portions GRa2. Descriptions about the first groove portions GRa1 may correspond to the descriptions about the groove portions GR overlapping the non-light-emitting area NPXA described with reference to FIGS. 3A and 3B. Accordingly, the second groove portions GRa2 will be mainly described in the following.

The second groove portions GRa2 may be arranged in a light emitting area PXA. The second groove portions GRa2 may include second groove portion side surfaces Sa2 substantially parallel to the third direction DR3 and second groove portion lower surface Ba2 facing the base layer 110.

Only a portion of the second cover layer CL2a may be removed in a direction from the upper surface to the lower surface of the second cover layer CL2a in an area overlapping the light emitting area PXA. Accordingly, at least a portion of the second cover layer CL2a may remain under the second groove portions GRa2 overlapping the light emitting area NPXA. That is, the second cover layer CL2a may not be completely penetrated in the light emitting area PXA, and the second cover layer CL2a may exist between the first cover layer CL1 and the third cover layer CL3a.

The second groove portions GRa2 may have a depth Da2 greater than a depth Da1 of the first groove portions GRa1. However, since the second cover layer CL2a is not completely penetrated in the light emitting area PXA, the depth Da2 of the second groove portions GRa2 may be smaller than a thickness of the second cover layer CL2a in the light-emitting area PXA and may be smaller than a distance between the upper surface of the second cover layer CL2a and an upper surface of the first cover layer CL1 in the light emitting area PXA.

The light blocking patterns BMa may include first light blocking patterns BMa1 and second light blocking patterns BMa2 having a different height from a height of the first light blocking patterns BMa1. The light blocking patterns BMa may include the first light blocking patterns BMa1 having a first height Ha1 and the second light blocking patterns BMa2 having a second height Ha2 greater than the first height Ha1. Here, the first height Ha1 and the second height Ha2 are lengths of the first light blocking patterns BMa1 and the second light blocking patterns BMa2 measured in the third direction DR3, respectively.

The first light blocking patterns BMa1 may be disposed in an inner space of the first groove portion GRa1. Descriptions about the first light blocking patterns BMa1 may correspond to the descriptions of the light blocking patterns BM disposed in the non-light-emitting area NPXA described with reference to FIGS. 3A and 3B, and details of the same elements will not be repeated.

The second light blocking patterns BMa2 may be disposed in an inner space of the second groove portion GRa2.

Since the second height Ha2 of the second light blocking patterns BMa2 is greater than the first height Ha1 of the first light blocking patterns BMa1, at least a portion of the second light blocking patterns BMa2 may overlap the first cover layer CL1 or a barrier wall PW in the first direction DR1. FIG. 4A shows the structure in which one side of the second light blocking patterns BMa2, which is relatively close to the base layer 110, overlaps the first cover layer CL1, a second barrier wall layer L2, and a portion of a first barrier wall layer L1 in the first direction DR1 as a representative example, however, the present disclosure should not be limited thereto or thereby.

Since the first light blocking patterns BMa1 have substantially the same height as each other, e.g., the first height Ha1, lower surfaces of the first light blocking patterns BMa1 may be aligned with each other in the first direction DR1.

Since the second light blocking patterns BMa2 have substantially the same height as each other, e.g., the second height Ha2, lower surfaces of the second light blocking patterns BMa2 may be aligned with each other in the first direction DR1.

In the first direction DR1, upper surfaces of the light blocking patterns BMa may be aligned with each other.

Since the second height Ha2 of the second light blocking patterns BMa2 is greater than the first height Ha1 of the first light blocking patterns BMa1, the lower surfaces of the second light blocking patterns BMa2 may protrude in the third direction DR3 more than the lower surfaces of the first light blocking patterns BMa1.

The first light blocking patterns BMa1 may be spaced apart from the barrier wall PW, and the second light blocking patterns BMa2 may overlap the barrier wall PW when viewed in the first direction DR1.

In addition, as a distance between the light blocking patterns BMa and the light emitting element layer 130 decreases, limitations on the emission angle of the light may increase. Therefore, a range of angle at which an image displayed on the display device 1000a is viewed may become narrower.

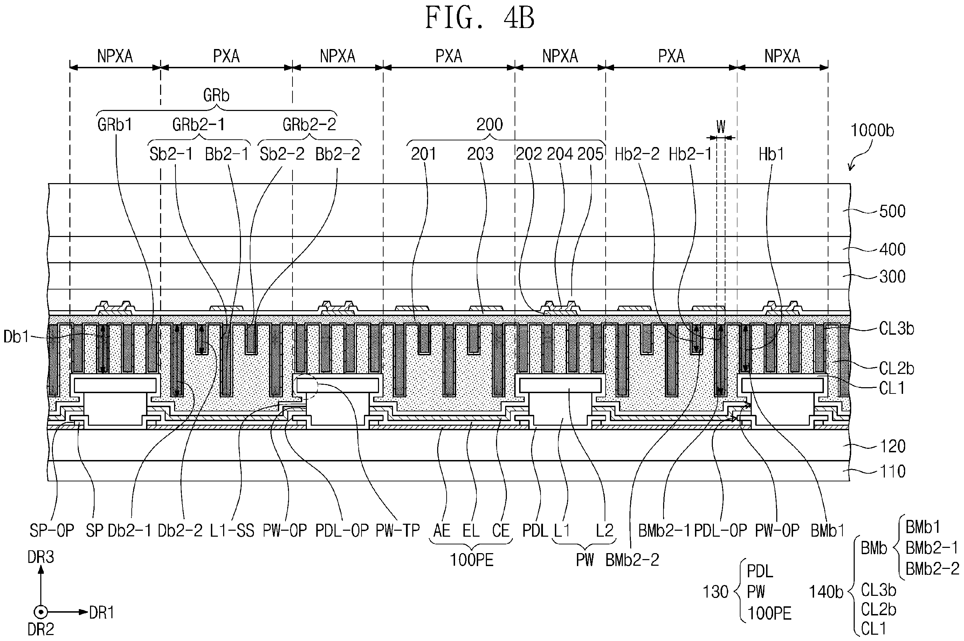

FIG. 4B is a cross-sectional view of a display device 1000b according to still another embodiment of the present disclosure.

Hereinafter, a stack structure of the display device 1000b will be described with reference to FIG. 4B.

The display device 1000b may include a base layer 110, a circuit layer 120, a light emitting element layer 130, an encapsulation layer 140b, a sensor layer 200, an optical layer 300, an adhesive layer 400, and a window 500.

In FIG. 4B, the same reference numerals denote the same elements in FIGS. 3A and 3B, and detailed descriptions of the same elements will be omitted. The following descriptions will be focused on different features.

The encapsulation layer 140b may be disposed on the light emitting element layer 130. The encapsulation layer 140b may include a first cover layer CL1, a second cover layer CL2b in which groove portions GRb are defined, light blocking patterns BMb, and a third cover layer CL3b.

Each of the groove portions GRb may be defined by outer surfaces of the second cover layer CL2b, which are defined by removing at least a portion of the second cover layer CL2b from an upper surface to a lower surface of the second cover layer CL2b.

The groove portions GRb may include first groove portions GRb1, second-first groove portions GRb2-1, and second-second groove portions GRb2-2. Descriptions about the first groove portions GRb1 may correspond to the descriptions of the groove portions GR overlapping the non-light-emitting area NPXA described with reference to FIGS. 3A and 3B. Accordingly, the following descriptions will be focused on the second-first groove portions GRb2-1 and the second-second groove portions GRb2-2.

The second-first groove portions GRb2-1 may be disposed in a light emitting area PXA. The second-first groove portions GRb2-1 may include second-first groove portion side surfaces Sb2-1 substantially parallel to the third direction DR3 and a second-first groove portion lower surface Bb2-1 facing the base layer 110.

The second-second groove portions GRb2-2 may be disposed in the light emitting area PXA. The second-second groove portions GRb2-2 may include second-second groove portion side surfaces Sb2-2 substantially parallel to the third direction DR3 and a second-second groove portion lower surface Bb2-2 facing the base layer 110.

Only a portion of the second cover layer CL2b may be removed in a direction from an upper surface to a lower surface of the second cover layer CL2b in an area overlapping the light emitting area PXA. Accordingly, at least a portion of the second cover layer CL2b may remain under the second-first and second-second groove portions GRb2-1 and GRb2-2 overlapping the light emitting area PXA. That is, the second cover layer CL2b may not be completely penetrated in the light emitting area PXA, and the second cover layer CL2b may exist between the first cover layer CL1 and the third cover layer CL3b.

The second-first groove portions GRb2-1 may have a depth Db2-1 greater than a depth Db1 of the first groove portions GRb1. However, since the second cover layer CL2b is not completely penetrated in the light emitting area PXA, the depth Db2-1 of the second-first groove portions GRb2-1 may be smaller than a thickness of the second cover layer CL2b in the light-emitting area PXA and may be smaller than a distance between the upper surface of the second cover layer CL2b and an upper surface of the first cover layer CL1 in the light emitting area PXA.

The depth Db2-2 of the second-second groove portions GRb2-2 may be different from the depth Db2-1 of the second-first groove portions GRb2-1. However, since the second cover layer CL2b is not completely penetrated in the light emitting area PXA, the depth Db2-2 of the second-second groove portions GRb2-2 may be smaller than the distance between the upper surface of the second cover layer CL2b and the upper surface of the first cover layer CL1 in the light emitting area PXA.

The second-first groove portions GRb2-1 may be alternately arranged with the second-second groove portions GRb2-2 in the light emitting area PXA.

The light blocking patterns BMb may include first light blocking patterns BMb1 having a first height Hb1, second-first light blocking patterns BMb2-1 having a second-first height Hb2-1, and second-second light blocking patterns BMb2-2 having a second-second height Hb2-2. The second-first height Hb2-1, the first height Hb1, and the second-second height Hb2-2 may be different from each other. However, according to an embodiment, the first height Hb1 may be substantially the same as the second-second height Hb2-2.

In the present specification, the second-second light blocking patterns BMb2-2 may also be referred to as "third light blocking patterns." In this case, the second-first height Hb2-1 may be referred to as the "second height", and the second-second height Hb2-2 may be referred to as the "third height".

In the first direction DR1, upper surfaces of the light blocking patterns BMb may be aligned with each other.

Since the second-first height Hb2-1 of the second-first light blocking patterns BMb2-1 is greater than the first height Hb1 of the first light blocking patterns BMb1, lower surfaces of the second-first light blocking patterns BMb2-1 may protrude in the third direction DR3 more than lower surfaces of the first light blocking patterns BMb1.

According to an embodiment, in a case where the second-second height Hb2-2 of the second-second light blocking patterns BMb2-2 is greater than the second-first height Hb2-1 of the second-first light blocking patterns BMb2-1, lower surfaces of the second-second light blocking patterns BMb2-2 may protrude in the third direction DR3 more than lower surfaces of the second-first light blocking patterns BMb2-1.

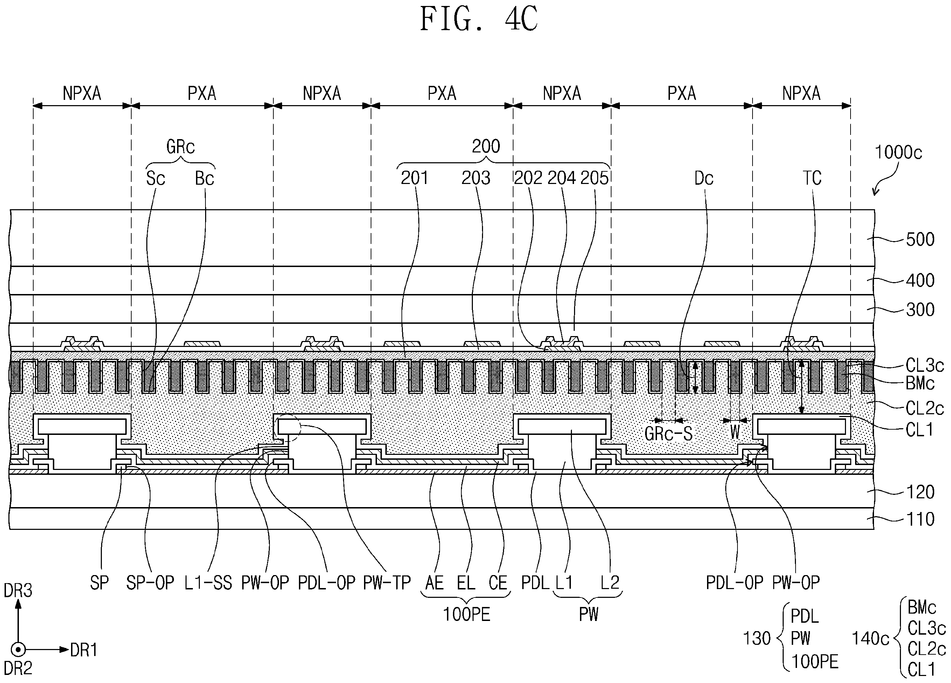

FIG. 4C is a cross-sectional view of a display device 1000c according to yet another embodiment of the present disclosure.

Hereinafter, a stack structure of the display device 1000c will be described with reference to FIG. 4C.

The display device 1000c may include a base layer 110, a circuit layer 120, a light emitting element layer 130, an encapsulation layer 140c, a sensor layer 200, an optical layer 300, an adhesive layer 400, and a window 500.

In FIG. 4C, the same reference numerals denote the same elements in FIGS. 3A and 3B, and detailed descriptions of the same elements will be omitted. The following descriptions will be focused on different features.

A depth Dc of groove portions GRc may be smaller than a maximum thickness TC in the third direction DR3 of a second cover layer CL2c in a non-light-emitting area NPXA. The maximum thickness TC of the second cover layer CL2c in a non-light-emitting area NPXA is a thickness of the second cover layer CL2c in a certain area of a non-light-emitting area NPXA, where it does not overlap the light blocking pattern BMc in a plan view.

A first cover layer CL1 may be spaced apart from a third cover layer CL3c with the second cover layer CL2c interposed therebetween. The second cover layer CL2c may be disposed under the groove portions GRc without being removed.

The second cover layer CL2c may have an integrally continuous shape without being separated or disconnected by the groove portions GRc in an area overlapping the non-light-emitting area NPXA.

As the second cover layer CL2c has the integrally continuous shape, a structural stability of the second cover layer CL2c may increase. In addition, a height of the light blocking patterns BMc may decrease, and thus, a cost required to form the light blocking patterns BMc may be reduced.

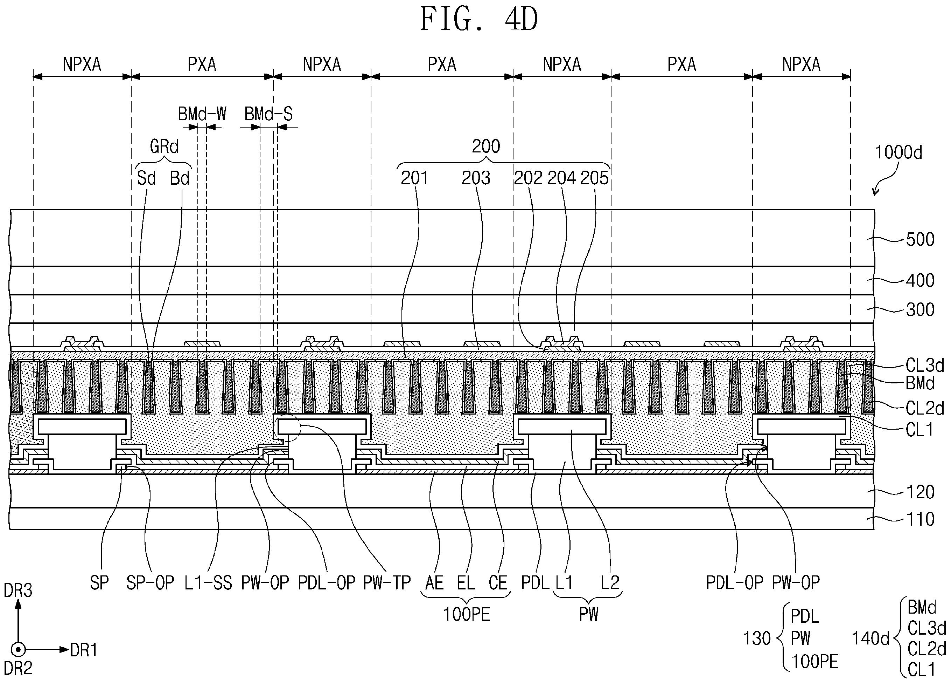

FIG. 4D is a cross-sectional view of a display device 1000d according to still another embodiment of the present disclosure.

Hereinafter, a stack structure of the display device 1000d will be described with reference to FIG. 4D.

The display device 1000d may include a base layer 110, a circuit layer 120, a light emitting element layer 130, an encapsulation layer 140d, a sensor layer 200, an optical layer 300, an adhesive layer 400, and a window 500.

In FIG. 4D, the same/similar reference numerals denote the same/similar elements in FIGS. 3A and 3B, and detailed descriptions of the same/similar elements will be omitted. The following descriptions will be focused on different features.

Each of groove portions GRd may be defined by outer surfaces of a second cover layer CL2d, which are formed by removing at least a portion of the second cover layer CL2d in a diagonal direction from an upper surface to a lower surface of the second cover layer CL2d. In the present disclosure, the diagonal direction may be defined as a direction between the third direction DR3 and the first direction DR1.

The groove portions GRd may include groove portion side surfaces Sd inclined to the diagonal direction. In addition, the groove portions GRd may further include a groove portion lower surface Bd facing the base layer 110 in an area overlapping a non-light-emitting area NPXA.

The groove portions GRd may be arranged in the first direction DR1, and each of light blocking patterns BMd may have a shape whose width decreases going from a lower portion to an upper portion of each of the light blocking patterns BMd when viewed in the second direction DR2.

As shown in FIG. 4D, the cross-section of each of the light blocking patterns BMd may have a trapezoidal shape with a bottom side wider than a top side. However, the cross-sectional shape of the light blocking patterns BMd should not be limited thereto or thereby as long as the width of the cross-sectional shape of each of the light blocking patterns BMd decreases going from the lower portion to the upper portion and may have a triangular shape or a shape obtained by cutting an oval in half.

The light blocking patterns BMd may be arranged in the first direction DR1, and in the cross-section defined by the first direction DR1 and the third direction DR3, the light blocking patterns BMd may have a shape whose width decreases going from the lower portion to the upper portion where the width narrows from the lower portion to the upper portion.

Referring to FIG. 4D, the second cover layer CL2d may be completely removed in the diagonal direction from the upper surface to the lower surface in a portion of the area overlapping the non-light-emitting area NPXA. That is, the groove portions GRd overlapping the non-light-emitting area NPXA may be formed to completely penetrate the second cover layer CL2d from the upper surface to the lower surface of the second cover layer CL2d.

As a width BMd-W of the cross-sectional shape of each of the light blocking patterns BMd decreases going from the lower portion to the upper portion, a distance BMd-S between the light blocking patterns BMd adjacent to each other may increase going from the lower portion to the upper portion. Accordingly, among lights entering between the light blocking patterns BMd adjacent to each other, a proportion of lights that travel in the third direction DR3 and exit to the outside of the display device 1000d may increase.

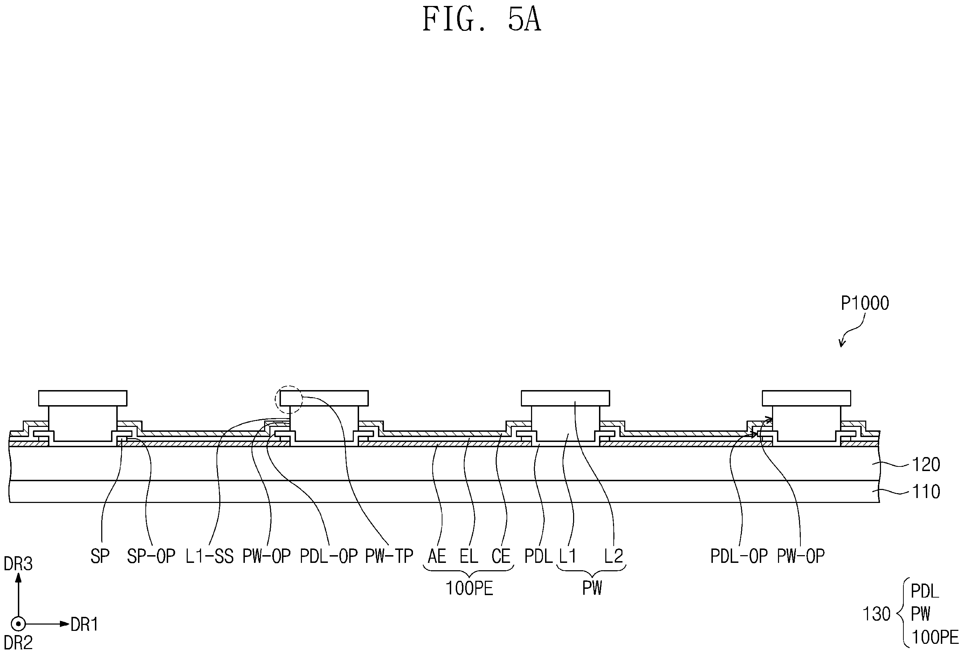

FIGS. 5A to 5K are cross-sectional views illustrating a method of manufacturing a display device according to an embodiment of the present disclosure.

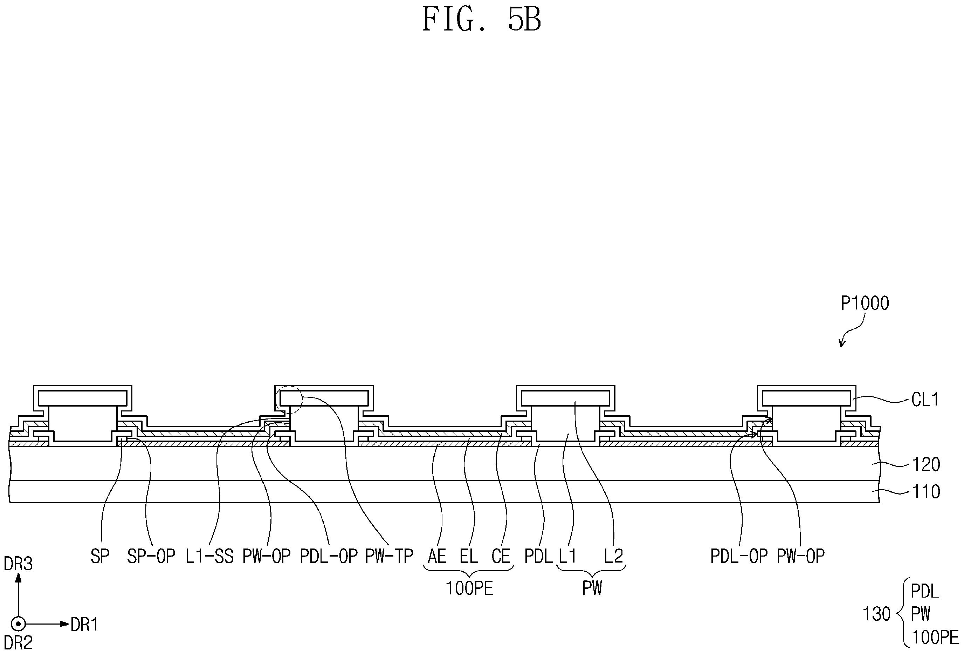

A process of forming the first cover layer will be described with reference to FIGS. 5A and 5B.

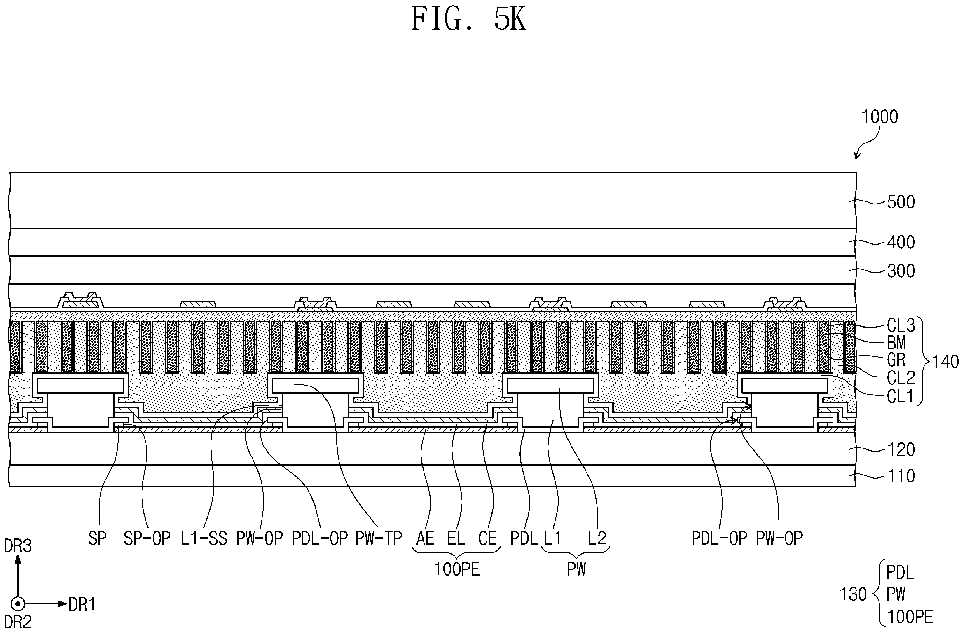

For the convenience of explanation, a preliminary display device P1000 refers to the display device 1000 in a state that is not yet completed in a manufacturing process of the display device 1000 (refer to FIG. 5K).

The preliminary display device P1000 may include the base layer 110, the light emitting element layer 130 disposed on the base layer 110 and including the light emitting element 100PE, the pixel definition layer PDL disposed on the base layer 110 and provided with the light emitting openings PDL-OP defined therethrough to overlap the light emitting elements in a plan view, and the barrier wall PW including the first barrier wall layer L1 disposed on the pixel definition layer PDL and the second barrier wall layer L2 disposed on the first barrier wall layer L1 and provided with the barrier wall openings PW-OP defined therethrough to overlap the light emitting openings PDL-OP in a plan view. In FIGS. 5A to 5K, the same reference numerals denote the same elements of FIG. 3A, and detailed descriptions of the same elements will be omitted.

After the preliminary display device P1000 is provided, a process of forming the first cover layer CL1 may be performed to cover the light emitting element layer 130 and the barrier wall PW. The process of forming the first cover layer CL1 may be performed using a chemical vapor deposition ("CVD") method or an atomic layer deposition ("ALD") method.

When the chemical vapor deposition (CVD) method or the atomic layer deposition (ALD) method is performed, the first cover layer CL1 may be deposited to cover the upper surface of the second electrode CE, the side surface L1-SS of the first barrier wall layer L1, which is in contact with the second electrode CE, and at least the portion of the lower surface of the second barrier wall layer L2, which is exposed without being covered by the first barrier wall layer L1, and the side and upper surfaces of the second barrier wall layer L2.

The first cover layer CL1 may protect the light emitting element layer 130 from moisture and oxygen. The first cover layer CL1 may include a silicon nitride layer, a silicon oxynitride layer, a silicon oxide layer, a titanium oxide layer, and an aluminum oxide layer.

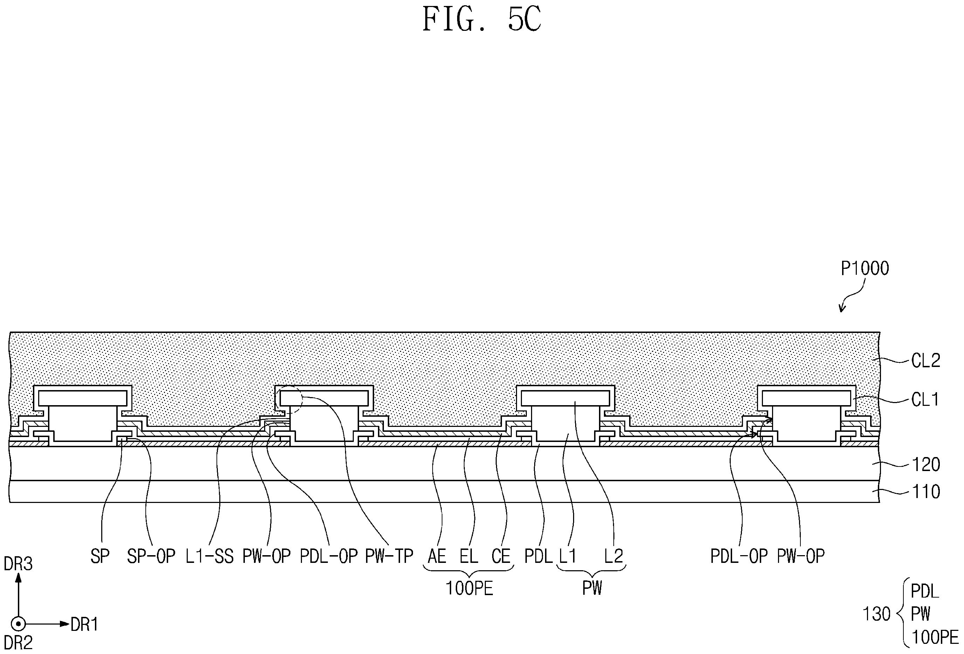

Then, a process of forming the second cover layer CL2 in the preliminary display device P1000 and a process of etching the second cover layer CL2 to form the groove portions GR will be described with reference to FIGS. 5C to 5F.

After the first cover layer CL1 is formed, the process of forming the second cover layer CL2 on the first cover layer CL1 may be performed.

The process of forming the second cover layer CL2 may be performed by an organic material deposition process. The second cover layer CL2 may be formed through the deposition process and may provide a flat upper surface thereon, and in a case where the second cover layer CL2 is formed through the deposition process, organic materials other than a liquid monomer may be provided.

The process of forming the second cover layer CL2 should not be limited thereto or thereby, and the second cover layer CL2 may be formed by an inkjet method that provides a liquid organic material on the first cover layer CL1 to form an organic layer.

The organic material for the second cover layer CL2 may include a monomer or a polymer. In an embodiment, for example, the organic layer may include at least one of an acrylic resin, an epoxy resin, and a silicon oxycarbide (SiOC). However, the organic material for the second cover layer CL2 should not be limited thereto or thereby.

The process of forming the second cover layer CL2 may be performed at a temperature equal to or greater than 25 degrees in Celsius (°C) and equal to or smaller than 100°C. Since the second cover layer CL2 is formed at a low temperature, layers and various elements under the second cover layer CL2 may be prevented from being thermally damaged.

A photoresist process may be performed on the second cover layer CL2 after a pattern mask MK is disposed on the second cover layer CL2. Since the upper surface of the second cover layer CL2 is flat, the pattern mask MK may be disposed on the second cover layer CL2. The pattern mask MK may be provided with a pattern opening MK-OP defined therethrough, and a shape and arrangement of the pattern openings MK-OP in a plan view may correspond to the shape and arrangement of the groove portions GR formed in the second cover layer CL2 in a plan view.

Each of the pattern openings MK-OP may have a width equal to or greater than 0.1 µm and equal to or smaller than 10 µm, however, it should not be limited thereto or thereby.

Then, a process of removing at least a portion of the second cover layer CL2 from the upper surface of the second cover layer CL2 may be performed to form the groove portions GR spaced apart from each other. In an embodiment, for example, the process of forming the groove portions GR may be performed by a dry etching process that etches the portion of the upper surface of the second cover layer CL2 using plasma. Accordingly, the groove portions GR may be anisotropically formed in the second cover layer CL2, and thus, the groove portions GR may be formed to have a sufficient depth.

When the groove portions GR are formed, the pattern mask MK disposed on the second cover layer CL2 may be removed.

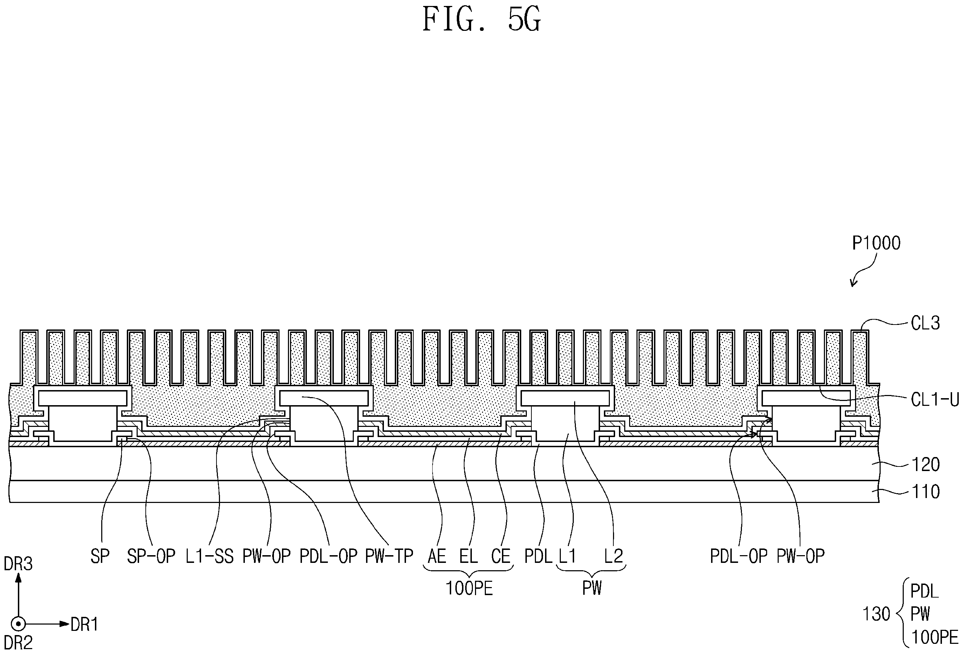

Hereinafter, a process of forming the third cover layer CL3 and the light blocking patterns BM will be described with reference to FIGS. 5G to 5I.

The third cover layer CL3 may be formed to cover the groove portion side surfaces S and the upper surface of the second cover layer CL2. In addition, the third cover layer CL3 may be formed to cover the groove portion lower surface B or the first cover layer CL1. In an embodiment, for example, the groove portions GR may be formed to completely penetrate the second cover layer CL2 in the area overlapping the non-light-emitting area NPXA, and thus, the third cover layer CL3 may be formed to cover the first cover layer CL1.

The process of forming the third cover layer CL3 may be performed by the atomic layer deposition (ALD) method. Thus, the variation in thickness of the third cover layer CL3 may be alleviated, and the step coverage may be improved.

The third cover layer CL3 may include silicon oxide (SiOx), metal oxide, or metal. Accordingly, the surface of the third cover layer CL3 may have a hydrophilic property. As described later, in the case where the material used to form the light blocking patterns BM has the hydrophilic property, the light blocking patterns BM may be easily formed to the inside of the groove portions GR.

Then, the process of forming the light blocking patterns BM in the groove portions GR may be performed. The process of forming the light blocking patterns BM in the groove portions GR may be performed by a slit coating or inkjet process. Accordingly, a light shielding material including carbon black or graphene may be filled in the inner space GR-SP of the groove portions GR (refer to FIG. 5E).

During the process of forming the light blocking patterns BM, first portions BM-P1, which correspond to a material used to form the light blocking patterns BM and filled the inner space GR-SP of the groove portions GR, may be formed in the preliminary display device P1000. The first portions BM-P1 may serve as the light blocking patterns BM in the display device 1000 (refer to FIG. 3A).

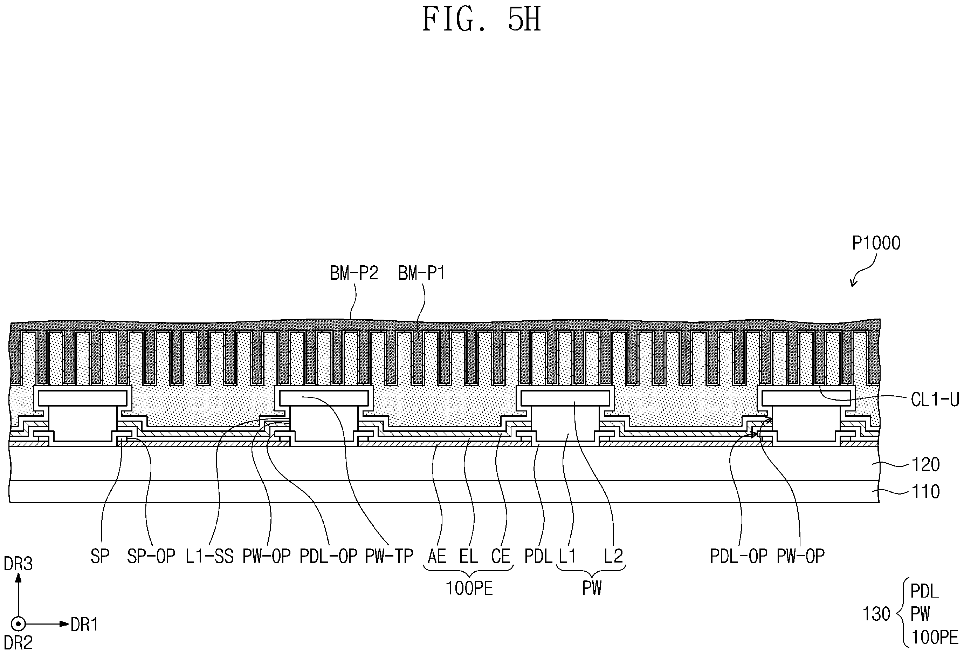

However, the material used to form the light blocking patterns BM may also be disposed outside of the inner space GR-SP (refer to FIG. 5E) of the groove portions and may be formed as second portions BM-P2 during the process of forming the light blocking patterns BM in the groove portions GR. The second portions BM-P2 may be referred to as an "upper remaining layer" formed during the process of forming the light blocking patterns BM (refer to FIG. 5H).

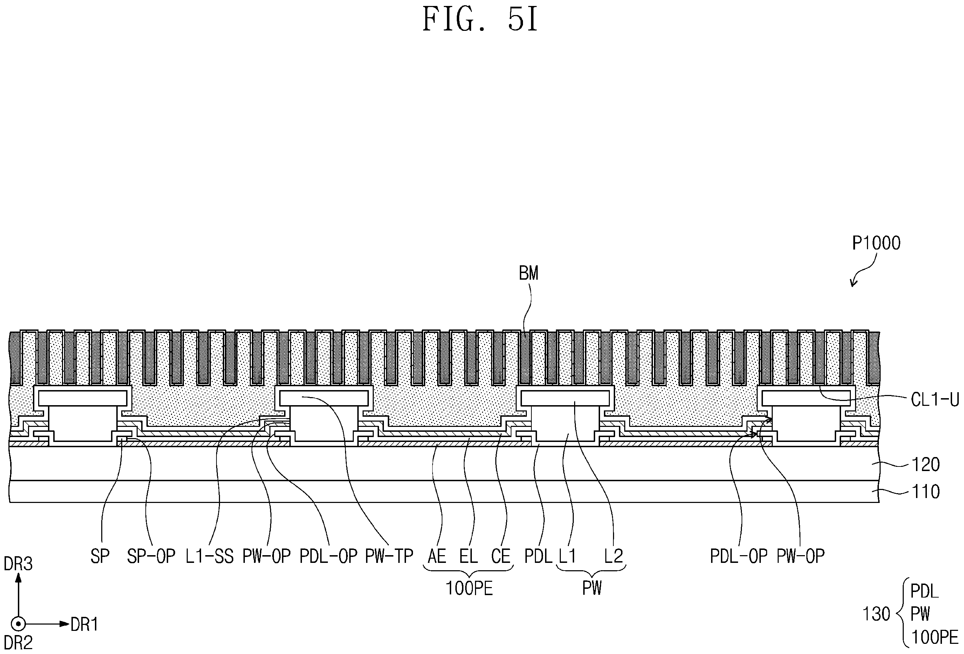

Then, a process of removing the second portions BM-P2 may be performed. The process of removing the second portions BM-P2 may be performed by a chemical mechanical polishing ("CMP") process or an ashing process. Accordingly, the upper remaining layer may be removed and the light blocking patterns BM may be formed as shown in FIG. 5I.

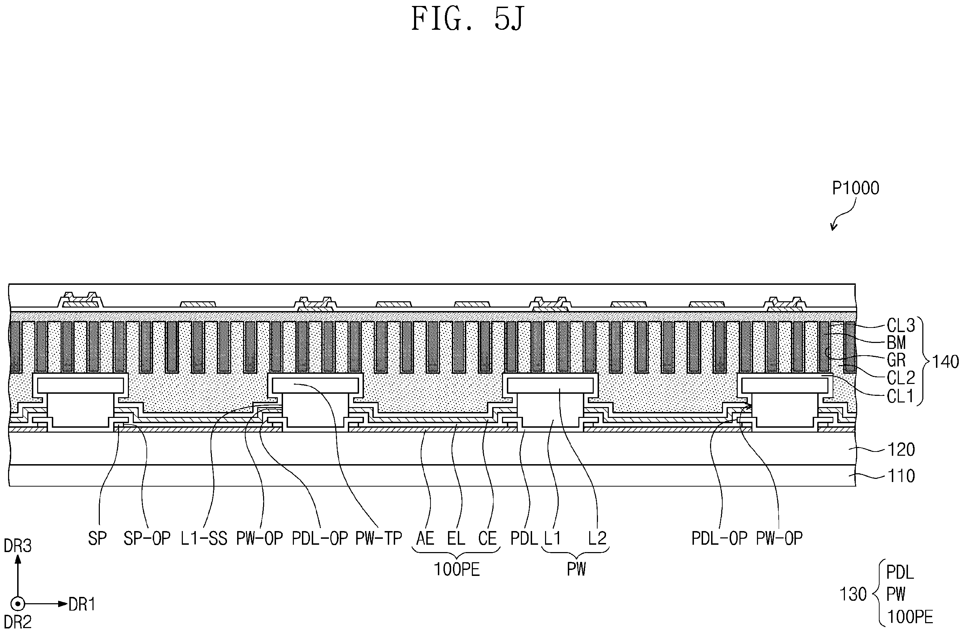

Referring to FIG. 5J, a process of forming the sensor layer 200 on the third cover layer CL3 may be performed. The sensor layer 200 may be formed on the display layer 100 through successive processes.

The first sensing insulating layer 201 may be formed by depositing an inorganic material on the encapsulation layer 140. The first conductive layer 202 may be formed by coating a conductive material on the first sensing insulating layer 201 and selectively patterning the coated conductive material using a photolithography process.

The second sensing insulating layer 203 may be formed on the first sensing insulating layer 201 through a deposition process. Then, the second conductive layer 204 may be formed by coating a conductive material on the second sensing insulating layer 203, and the cover insulating layer 205 may be formed by depositing an inorganic material on the second conductive layer 204.

Referring to FIG. 5K, processes of forming the optical layer 300, the adhesive layer 400, and the window 500 on the sensor layer 200 may be performed. The processes of forming the optical layer 300, the adhesive layer 400, and the window 500 may be sequentially performed.

Although the embodiments of the present disclosure have been described, it is understood that the present disclosure should not be limited to these embodiments but various changes and modifications can be made by one ordinary skilled in the art within the scope of the present disclosure as hereinafter claimed.

Therefore, the disclosed subject matter should not be limited to any single embodiment described herein, and the scope of the present invention shall be determined according to the attached claims.

## Claims

1. A display device (1000, 1000a, 1000b, 1000c, 1000d, 2000) comprising:
a base layer (110) comprising a light emitting area (PXA) and a non-light-emitting area (NPXA) surrounding the light emitting area (PXA);
a light emitting element layer (130) disposed on the base layer (110) and comprising light emitting elements (100PE);
a pixel definition layer (PDL) disposed on the base layer (110) and provided with light emitting openings (PDL-OP) overlapping the light emitting elements (100PE) in a plan view;
a barrier wall (PW) comprising a first barrier wall layer (L1) disposed on the pixel definition layer (PDL) and a second barrier wall layer (L2) disposed on the first barrier wall layer (L1), wherein the barrier wall (PW) is provided with barrier wall openings (PW-OP) overlapping the light emitting openings (PDL-OP) in the plan view;
an encapsulation layer (140, 140a, 140b, 140c, 140d) covering the light emitting elements (100PE); and
a sensor layer (200) disposed on the encapsulation layer (140, 140a, 140b, 140c, 140d), the encapsulation layer (140, 140a, 140b, 140c, 140d) comprising:
a first cover layer (CL1) covering the light emitting element layer (130) and the barrier wall (PW);
a second cover layer (CL2, CL2a, CL2b, CL2c, CL2d) disposed on the first cover layer (CL1) and provided with groove portions (GR, GRa, GRb, GRc, GRd), wherein the groove portions (GR, GRa, GRb, GRc, GRd) are defined therein by recessing portions of the second cover layer (CL2, CL2a, CL2b, CL2c, CL2d) from an upper surface of the second cover layer (CL2, CL2a, CL2b, CL2c, CL2d) and spaced apart from each other;
a third cover layer (CL3, CL3a, CL3b, CL3c, CL3d) disposed on the second cover layer (CL2, CL2a, CL2b, CL2c, CL2d); and
light blocking patterns (BM, BMa, BMb, BMc, BMd) disposed in the groove portions (GR, GRa, GRb, GRc, GRd).

2. The display device (1000, 1000a, 1000b, 1000c, 1000d) of claim 1, wherein the light blocking patterns (BM, BMa, BMb, BMc, BMd) are arranged in a first direction (DR1), and wherein in a cross-section parallel to the first direction (DR1) and perpendicular to an upper surface of the base layer (110), each of the light blocking patterns (BM, BMa, BMb, BMc, BMd) has a rectangular shape or a shape whose width (BMd-W) decreases in a direction (DR3) from a lower portion to an upper portion thereof.

3. The display device (1000, 1000a, 1000b, 1000c, 1000d, 2000) of claim 1 or 2, wherein the light blocking patterns (BM, BMa, BMb, BMc, BMd) comprise a carbon black or a graphene.

4. The display device (1000, 1000a, 1000b, 1000c, 1000d, 2000) of one of the preceding claims, wherein the light blocking patterns (BM, BMa, BMb, BMc, BMd) have a dielectric constant equal to or greater than 1 Farad per meter (F/m) and equal to or smaller than 3 F/m.

5. The display device (1000, 1000a, 1000b, 1000c, 1000d, 2000) of one of the preceding claims, wherein each of the groove portions (GR, GRa, GRb, GRc, GRd) has a width (GR-W) equal to or greater than 0.1 micrometers and equal to or smaller than 10 micrometers, and a separation distance (GR-S) between two of the groove portions (GR, GRa, GRb, GRc, GRd) adjacent to each other is equal to or greater than 0.1 micrometers and equal to or smaller than 10 micrometers.

6. The display device (1000, 1000a, 1000b, 1000c, 1000d, 2000) of one of the preceding claims, wherein each of the light blocking patterns (BM, BMa, BMb, BMc, BMd) has a width (W) equal to or greater than 1 micrometers and equal to or smaller than 1.5 micrometers, each of the light blocking patterns (BM, BMa, BMb, BMc, BMd) has a height (H) equal to or greater than 4.5 micrometers and equal to or smaller than 10 micrometers, and a separation distance (BM-S) between two of the light blocking patterns (BM, BMa, BMb, BMc, BMd) adjacent to each other is equal to or greater than 1 micrometers and equal to or smaller than 100 micrometers.

7. The display device (1000, 1000a, 1000b, 1000c, 1000d, 2000) of one of the preceding claims, wherein the first cover layer (CL1) comprises at least one of silicon nitride, silicon oxynitride, silicon oxide, titanium oxide, and aluminum oxide, the second cover layer (CL2, CL2a, CL2b, CL2c, CL2d) comprises at least one of an acrylic resin, an epoxy resin, and a silicon oxycarbide, and the third cover layer (CL3, CL3a, CL3b, CL3c, CL3d) comprises at least one of silicon oxide, metal oxide, and metal.

8. The display device (1000, 1000a, 1000b, 1000d, 2000) of one of the preceding claims, wherein at least a portion of the first cover layer (CL1) , which covers an upper surface of the second barrier wall layer (L2), is exposed through the groove portions (GR, GRa, GRb, GRd) in the non-light emitting area (NPXA) and is in contact with the third cover layer (CL3, CL3a, CL3b, CL3d).

9. The display device (1000a, 1000b) of one of the preceding claims, wherein the light blocking patterns (BMa, BMb) comprise:
first light blocking patterns (BMa1, BMb1) having a first height (Ha1, Hb1); and
second light blocking patterns (BMa2, BMb2-1) having a second height (Ha2, Hb2-1) larger than the first height (Ha1, Hb1),
wherein the first light blocking patterns (BMa1, BMb1) are spaced apart from the barrier wall (PW), and the second light blocking patterns (BMa2, BMb2-1) overlap the barrier wall (PW) in a first direction (DR1).

10. The display device (1000b) of claim 9, wherein the light blocking patterns (BMb) further comprise third light blocking patterns (BMb2-2) having a third height (Hb2-2),
wherein the third light blocking patterns (BMb2-2) are spaced apart from the barrier wall (PW), and the third height (Hb2-2) is different from the second height (Hb2-1).

11. The display device (1000c) of one of claims 1 to 8, wherein the groove portions (GRc) each has a depth (Dc) smaller than a distance from an upper surface of the second cover layer (CL2c) to an upper surface of the first cover layer (CL1) in the non-light-emitting area (NPXA), and a portion of the first cover layer (CL1) covering an upper surface of the second barrier wall layer (L2) is spaced apart from the third cover layer (CL3c) with the second cover layer (CL2c) interposed therebetween.

12. The display device (1000, 1000a, 1000b, 1000c, 1000d, 2000) of one of the preceding claims, wherein each of the light emitting elements (100PE) comprises:
a first electrode (AE) disposed in a corresponding barrier wall opening (PW-OP) among the barrier wall openings;
a light emitting layer (EL) disposed on the first electrode (AE); and
a second electrode (CE) disposed on the light emitting layer (AE),
wherein the second electrodes (CE) are in contact with the first barrier wall layer (L1), the first barrier wall layer (L1) comprises aluminum, and the second barrier wall layer (L2) comprises titanium.

13. A method of manufacturing a display device (1000), the method comprising:
providing a preliminary display device (P1000) comprising a base layer (110), a light emitting element layer (130) disposed on the base layer (110) and comprising light emitting elements (EL), a pixel definition layer (PDL) disposed on the base layer (110) and provided with light emitting openings (PDL-OP) overlapping the light emitting elements (EL), a barrier wall (PW) comprising a first barrier wall layer (L1) disposed on the pixel definition layer (PDL) and a second barrier wall layer (L2) disposed on the first barrier wall layer (L1) and provided with barrier wall openings (PW-OP) overlapping the light emitting openings (PDL-OP);
forming a first cover layer (CL1) to cover the light emitting element layer (130) and the barrier wall (PW);
forming a second cover layer (CL2) on the first cover layer (CL1);
forming groove portions (GR) defined by removing at least portions of the second cover layer (CL2) from an upper surface of the second cover layer (CL2) and spaced apart from each other in a first direction (DR1);
forming a third cover layer (CL3) to cover side surfaces (S) of the groove portions (GR) and an upper surface of the second cover layer (CL2);
forming light blocking patterns (BM) in an inner space of the groove portions (GR); and
forming a sensor layer (200) disposed on the third cover layer (CL3).

14. The method of claim 13, wherein the forming of the groove portions (GR) comprises dry-etching the portions of the second cover layer (CL2) from the upper surface of the second cover layer (CL2).

15. The method of claim 13 or 14, further comprising removing an upper remaining layer (BM-P2) comprising a material for the light blocking patterns (BM) and disposed outside of the groove portions (GR) between the forming of the light blocking patterns (BM) and the forming of the sensor layer (200), wherein the removing of the upper remaining layer (BM-P2) is performed by a chemical mechanical polishing process or an ashing process.
